Europäisches Patentamt

(19) European Patent Office

Office européen des brevets

(11) Publication number: **0 010 920**
**A1**

## (12) EUROPEAN PATENT APPLICATION

(21) Application number: **79302313.6**

(22) Date of filing: **24.10.79**

(51) Int. Cl.³: **C 30 B 19/10,** C 30 B 29/28, G 02 F 1/00

---

(30) Priority: **25.10.78 US 954511**

(43) Date of publication of application: **14.05.80**
**Bulletin 80/10**

(84) Designated Contracting States: **DE FR GB IT**

(71) Applicant: **SPERRY RAND CORPORATION, 1290, Avenue of the Americas, New York N.Y. 10019 (US)**

(72) Inventor: **Nelson, Gary Lee, 3232 Valley Ridge Drive, Eagan Minnesota 55121 Dakota County (US)**
Inventor: **Harvey, William Albert, 2615 Eighth Street South Minneapolis, Minnesota 55454 Hennepin (US)**

(74) Representative: **Michaels, Peter Albert, SPERRY UNIVAC Patent & Licensing Services M.S. S2 W1 SPERRY UNIVAC CENTRE, London NW10 8LS (GB)**

---

(54) **Liquid phase epitaxial process.**

(57) In a liquid phase epitaxial process for producing magnetic garnet crystals, primary melt residues adhering to a magnetic garnet crystal (4) are removed by immersing the crystal (2, 4) subsequent to growth in a rinse melt at or near the growth temperature of the primary melt. The rinse melt has a saturation to nucleation temperature range overlapping that of the primary melt and encompassing its growth temperature, has a solvent different from that of the primary melt and saturated or super-saturated with respect to the primary melt's solute, and has no undesirable adhesion properties of its own.

The rinse melt enables residues of bismuth containing primary melts to be removed. Bismuth containing primary melts are used to improve the properties of garnet crystal structures (2, 4, 6, 8) used for magneto-optic light deflectors.

ACTORUM AG

## Liquid Phase Epitaxy

This invention relates to producing magnetic garnet crystal structures by liquid phase epitaxy (LPE). The invention has an important application in the production of crystal structures for magneto-optic light deflecting devices.

LPE magnetic garnet crystals are grown by immersing a suitably prepared substrate in a super-saturated primary melt for a predetermined growth period. At the end of the growth period the crystal-substrate combination is withdrawn from the primary melt. Residues of the primary melt adhering to the crystal have to be removed since on cooling they tend to cause cracking or fracturing of the crystal, or result in crystals of non-uniform magneto-optic properties, non-uniform thickness, or in otherwise defective or unusable crystals. The residues consist essentially of the primary melt's solvent compound, such as for instance $Bi_2O_3$, $PbO$, $Na_2O$, $V_2O_5$, or $B_2O_3$.

The problem of primary melt adhesion is particularly severe in, though by no means confined to, the case of magnetic garnet crystals grown from primary melts containing bismuth compound solvents. Primary melts containing bismuth compound solvents are known, for example, from U.K. patent 1 439 346 (published 16 June 1976), and are used to effect bismuth substitution in the LPE crystal. Bismuth substitution in the crystal lattice increases the coefficient of Faraday rotation and hence improves the magneto-optic characteristics of the magnetic garnet crystal. In previous work on growing LPE crystals not containing bismuth the residual coating could generally be removed by pulling the crystal from the primary melt and, with the crystal still nearly at growth temperature, mechanically spinning the crystal-substrate combination such that the centrifugal force overcomes the mechanical and chemical forces which cause the adhesion of the primary melt. In contrast, work on various bismuth substituting primary melts has often been hampered in the past by the inability to remove the residual primary melt satisfactorily by spinning, on account of the wetting characteristics and viscosities of such primary melts, especially if the crystal is grown at temperatures which ensure maximum bismuth substitution. Acid etching after cooling of the LPE crystals has been attempted, but has shown only limited effectiveness in that the damage usually occurs during the preceding cooling down period.

The present invention provides a solution to the problem of primary melt adhesion through a rinse process involving the use of rinse melts to remove the residual primary melt. The rinse process consists essentially of immersing the LPE crystal after growth in a rinse melt which solvates any residual primary melt adhering to it.

The rinse process is performed at a temperature within a range of temperatures which is defined by the overlap of the saturation to nucleation temperature ranges of the primary melt and the rinse melt, and which also includes the growth temperature of the primary melt.

In order to promote the solvation of the adhering primary melt solvent the rinse melt has a solvent compound which is different from the solvent of the primary melt while simultaneously being saturated or super-saturated with respect to the primary melt's solute compound. Also, the saturation to nucleation temperature range of the rinse melt includes the growth temperature of the primary melt. Additionally, the rinse melt should not, of course, have any undesirable adhesion problems of its own.

The advantages gained by using the rinse process taught by the present invention may be illustrated by the example of bismuth-vanadium solvents which allow LPE crystals to be grown which have potentially superior magneto-optic properties. However, these properties could heretofore not be measured because of the inability to remove the residual primary melt by conventional techniques, the crystals so far grown having been found upon cooling to be mechanically defective or otherwise unusable.

The present invention not only provides a solution to the problem of adhering primary melt residues, but at the same time permits the growth of a non-absorptive decoupling layer over the LPE crystal-substrate combination. The decoupling layer, if grown on a single layer structure, acts in much the same manner as a passivation layer in that it serves to protect the LPE crystal-substrate combination from damage to the LPE crystal's lattice structure and magnetic properties. If grown for a multi-layer structure, the decoupling layer generally consists of non-magnetic material and serves to decouple adjacent magnetic garnet layers in respect of exchange interaction, and to protect the underlying LPE crystal during the subsequent processing steps.

The invention shall now be described further by way of example and with reference to the accompanying drawings of which:-

Figure 1 is a schematic section through an LPE crystal-substrate combination including a decoupling layer;

Figure 2 shows graphs representing several growth temperature relationships between rinse melts and a bismuth-vanadium primary melt, and

Figure 3 is a schematic section through a multi-layer structure including an intermediate decoupling layer.

A rinse melt according to the present invention is obtained from a rinse melt mixture having the following properties: the rinse melt solvent is different from the solvent compound of the primary melt while simultaneously being saturated or super-saturated with respect to the primary melt's solute compound, the rinse melt saturation to nucleation temperature range encompasses the growth temperature of the primary melt; and the rinse melt has no undesirable adhesion properties of its own.

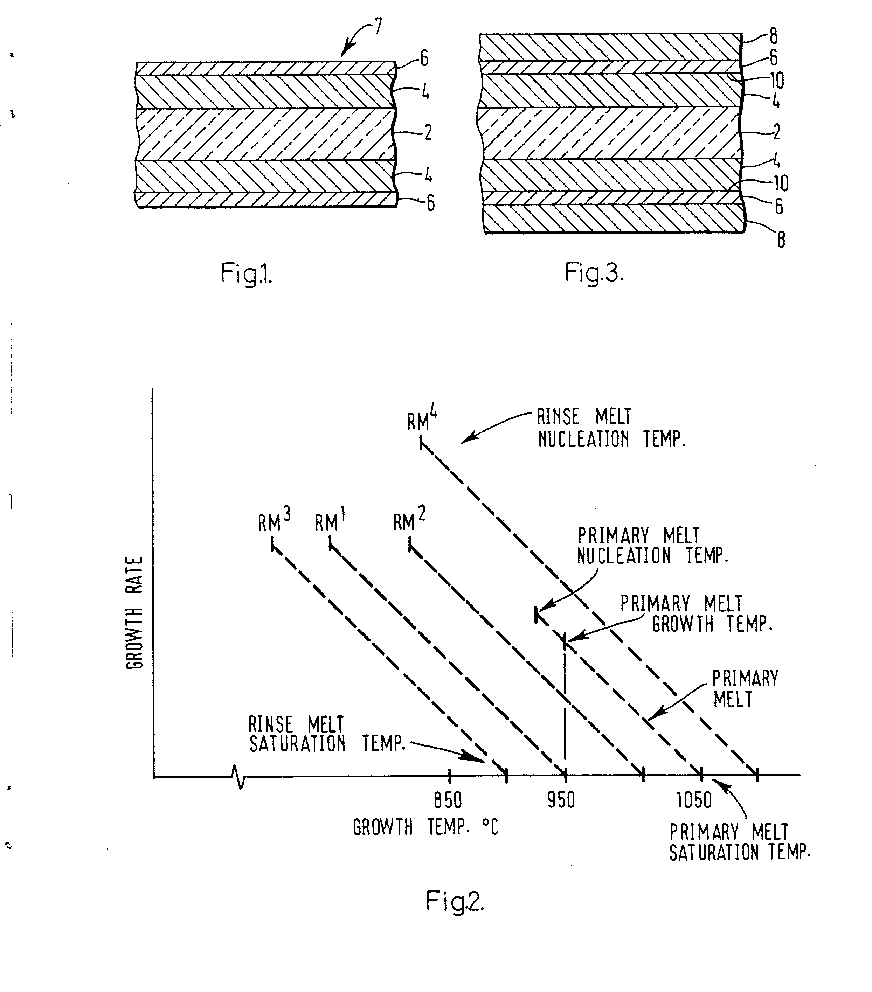

Referring now also to Figure 1, after the preparation of a rinse melt mixture having the afore-said properties, the LPE crystals are grown in the following manner and sequence of steps:

1) the rinse melt and primary melt mixture are simultaneously heated in separate platinum crucibles in an appropriate furnace and in a clean environment to a temperature on the order of $200^{o}C$ above the primary melt's growth temperature;

2) the melts are cooled to the primary melt growth temperature;

3) the substrate 2 after having been preheated to a temperature on the order of the primary melt growth temperature is immersed in the primary melt;

4) the substrate 2 is rotated during the growth period until an epitaxial crystal 4 of the desired thickness is grown;

5) the grown epitaxial crystal substrate combination 7 is withdrawn from the primary melt, and the combination 7, while still at a temperature very closely approximating the growth temperature, may be spun to remove as much of the primary melt residue as possible;

6) the epitaxial crystal-substrate combination 7 is next inserted into the rinse melt, which is at its saturation temperature or within its super-saturation temperature range but above its nucleation temperature, for a period sufficient to solvate the primary melt residue still adhering to the LPE crystal-substrate combination 7. (If the rinse melt temperature is held at its saturation point no additional growth action will occur but if it is within its super-saturation temperature range a decoupling layer 6 will grow over the epitaxial crystal-substrate combination 7.); the combination 7 structure with or without a decoupling layer 6 is finally withdrawn from the furnace in an appropriate manner to prevent thermal shock to the combination 7. It is to be observed that the rinse process must occur as close as possible to the primary melt's growth temperature, especially where the primary melt contains bismuth, and as soon as possible after the step 5 withdrawal to stop the growth action of the adhered primary melt residue which continues even after withdrawal.

Depending on the specific LPE crystal's 4 application further processing of the LPE crystal 4 can be performed by growing additional epitaxial crystal layers over the LPE crystal 4 or the decoupling layer 6 or mechanically or chemically preparing the geometries of the LPE crystal 4 such as mechanically removing or etching the crystal 4 and decoupling layer from one surface of the substrate 2, cutting the thus prepared combination to a specific shape or further shaping the LPE crystal 4 to obtain crystals free from undesirable defects.

-5-

The present invention differs from the LPE etch technique described in an article by J.M. Robertson, et al, appearing in the Journal of Crystal Growth 18 (1973) pp.294-296, entitled Garnet Substrate Preparation By Homoepitaxy, in that the above article describes the use of a melt composition corresponding to the composition of a non-magnetic supporting garnet substrate as an etchant for preparing the substrate's surface with the subsequent homoepitaxial growth on the etched substrate. The article does not anticipate compositions, and their use, for solvating primary melt residue adhering to LPE crystals grown in subsequent steps, in that the etching process described in the article requires the etching to occur at a temperature above the melt's saturation temperature with the subsequent lowering of the melt temperature into its super-saturation range to grow the homoepitaxial layer on the substrate to replace the etched portion and thereby achieve the relatively defect free surface on which to grow the LPE crystal layers. Such a melt mixture, however, may be used in conjunction with the teachings of the present invention (i.e. in the range between its saturation and nucleation temperature) to either solvate the primary melt residue or solvate the residue and grow a decoupling layer 6.

Specific rinse melt mixtures which have been applied in the manner described herein for a bismuth-vanadium primary melt having a growth temperature of $950^{\circ}$C are as follows:

### TABLE I

| Compound | Mol. % for (111) GGG Melt | Mol. % for (111) SmGG Melt |
|---|---|---|
| Solvent: | | |
| PbO | 87.50 | 85.68 |
| $B_2O_3$ | 7.50 | 7.34 |
| Solute: | | |
| $Ga_2O_3$ | 3.33 | 3.95 |
| $Gd_2O_3$ | 1.67 | - |
| $Sm_2O_3$ | - | 3.03 |

It is to be understood that the solute to solvent ratio, the solvent to solvent or the solute to solute ratio used in the rinse melt may be adjusted to shift the rinse melt's saturation to nucleation temperature range to match the growth temperature of the primary melt, to track precipitation phase changes with saturation temperature change and to compensate for the specific crystal orientation of the substrate. Such quantitative adjustments will usually be made experimentally by first adjusting the solute to solvent concentration to achieve temperature orientation and then adjusting the solute to solute ratio as necessary to achieve phase orientation.

Referring to Figures 1 and 2, the structure and the relative relationships of several representative rinse melt mixture growth curves of the type described herein to a bismuth-vanadium substituted primary melt are shown. The specific shape and slopes of the growth curves are not to scale as only the relative temperature relationships between the primary melt mixture's saturation to nucleation temperature range and the rinse melt mixtures' saturation to nucleation temperature range are of significance. Recognising that the primary melt growth temperature, approximately 950°C, is fixed at a temperature where the LPE bismuth substituted magnetic garnet to substrate lattice mismatch is minimised to relieve lattice strain, the rinse melt can be adjusted to produce a rinse melt growth curve having its saturation to nucleation temperature range encompass the primary melt's growth temperature. Where a rinse melt composition $RM^1$ is used, its saturation temperature matches the primary melt growth temperature, and the primary melt residue will be solvated during the rinse period but no additional growth will occur. For the $RM^2$ melt composition, solvation occurs and a decoupling layer 6 is grown whose thickness is dependent on the length of the rinse period. $RM^4$ represents the case where the rinse melt temperature range encompasses the primary melt temperature range and has a faster growth rate. To use a rinse melt having a saturation temperature below the primary growth temperature as in $RM^3$, however, would result in the undesirable etching of the LPE crystal 4 in the manner described in the Robertson article. The rinse melt solute, solvent and solute to solvent mixture ratios and the rinse period must therefore be selected so as to constrain the rinse melt saturation to nucleation temperature range to encompass the primary melt growth temperature and to provide for the desired amount of decoupling layer 6 growth.

The decoupling layer 6, which grows on the LPE crystal 4 when rinsing in the super-saturation region above the nucleation temperature of the rinse melt, while protecting the LPE crystal 4 from damage due to handling, etc., has also been discovered to protect the LPE crystal 4 from many of the deleterious effects which can result during any subsequent process steps, especially where another magnetic crystal is grown directly over the LPE crystal 4 in the next succeeding process steps.

Figure 3 shows a multilayer structure. It has been observed from past work that when an LPE magnetic garnet crystal 8 not containing bismuth is grown directly over an LPE magnetic garnet crystal 4 containing bismuth, the LPE crystal 4 containing bismuth is attacked in the interface region 10 such that the resulting multilayer structures are unusable. It is speculated that the LPE crystal 8 melt solvates the bismuth from the LPE crystal 4 but the exact reaction is not understood. Where, however, the crystal 8 not containing bismuth is grown over a decoupling layer 6 no deleterious mechanical, chemical or electrical effects are observed to the LPE crystal 4 containing bismuth or the LPE crystal 8 not containing bismuth.

While this destructive interaction has occurred in some instances, it should further be recognised that there are LPE magnetic garnet crystal melts which can be grown directly over the bismuth containing magnetic garnet crystal 6 and the subsequent magnetic garnet crystal 8 melt can also be used as the rinse melt. A melt mixture which could be expected to meet these requirements is a YIG - PbO melt such as disclosed in Table II. Such a melt possesses the attributes described herein and permits the minimisation of process steps.

-8-

## TABLE II

| Compound | Mol. % for (111) GGG Melt |
|----------|---------------------------|
| Solvent: | |
| PbO | 78.73 |
| $B_2O_3$ | 12.28 |
| Solute: | |
| $Y_2O_3$ | 8.35 |
| $Fe_2O_3$ | .64 |

-1-

## CLAIMS

1.     A liquid phase epitaxial process for producing a magnetic garnet crystal structure including the step of growing a magnetic garnet crystal (4) on a garnet substrate (2) from a solvent-containing primary melt at a growth temperature in the saturation to nucleation temperature range of the primary melt, characterised in that primary melt residues adhering to the grown crystal (4) are removed by immersing the grown crystal (4) following its withdrawal from the primary melt, in a rinse melt having a solvent different from that of the primary melt and being saturated or super-saturated with respect to the solute of the primary melt, the rinse melt being at a temperature within a temperature range in which the saturation to nucleation temperature ranges of the primary melt and the rinse melt overlap and in which the growth temperature of the primary melt is included, the grown crystal being immersed in the rinse melt at least until the primary melt residues are removed.

2.     A process according to claim 1, characterised in that the primary melt contains a bismuth solvent compound for growing bismuth substituted magnetic garnet crystals (4).

3.     A process according to claim 1 or 2, characterised in that the rinse melt is at the growth temperature of the primary melt and has at that growth temperature a precipitation phase identical to the supporting substrate (2).

4.     A process according to claim 2 or 3, characterised in that the substrate (2) is a gadolinium gallium garnet ($Gd_3 Ga_5 O_{12}$) and the rinse melt consists essentially of:

| | |
|---|---|
| $Gd_2O_3$ | 1.67 Mol. % |
| $Ga_2O_3$ | 3.33 Mol. % |
| PbO | 87.50 Mol. % |
| $B_2O_3$ | 7.50 Mol. % |

5.    A process according to claim 2 or 3 characterised in that the substrate (2) is a samarium gallium garnet ($Sm_3 Ga_5 O_{12}$) and the rinse melt mixture consists essentially of:

| | |
|---|---|
| $Sm_2O_3$ | 3.03 Mol. % |
| $Ga_2O_3$ | 3.95 Mol. % |
| PbO | 85.68 Mol. % |
| $B_2O_3$ | 7.34 Mol. % |

6.    A process according to claim 1 or 2 characterised in that the saturation temperature of the rinse melt is greater than the growth temperature of the primary melt and the immersion of the grown crystal (4) in the rinse melt is extended beyond the period necessary to solvate the primary melt residues thereby to grow epitaxially a decoupling layer (6) from the rinse melt over the grown crystal (4).

7.    A process according to claim 1 or 2 characterised in that the rinse melt is at its saturation temperature and the saturation temperature of the rinse melt is equal to the growth temperature of the primary melt.

8.    A process according to claim 1 or 2 characterised in that the rinse melt consists essentially of:

| | |
|---|---|
| PbO | 78.73 Mol. % |
| $B_2O_3$ | 12.28 Mol. % |
| $Y_2O_3$ | 8.35 Mol. % |
| $Fe_2O_3$ | 0.64 Mol. % |

Fig.1.

Fig.3.

Fig.2.

## DOCUMENTS CONSIDERED TO BE RELEVANT

| Category | Citation of document with indication, where appropriate, of relevant passages | Relevant to claim |
|---|---|---|
| A | FR - A - 2 195 069 (MATSUSHITA ELECTRONICS)<br>* Claims 1,4; figure 3 *<br><br>-- | 1 |
| A | US - A - 4 028 148 (Y. HORIKOSHI)<br>* Claim 1 *<br><br>-- | 1 |
| A | US - A - 3 692 593 (F.Z. HAWRYLO)<br><br>---- |  |

**CLASSIFICATION OF THE APPLICATION (Int. Cl. 3)**

C 30 B 19/10
C 30 B 29/28
G 02 F 1/00

**TECHNICAL FIELDS SEARCHED (Int.Cl. 3)**

C 30 B 19/10
C 30 B 29/28
C 30 B 19/02
C 30 B 19/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 09-01-1980 | BRACKE |

EPO Form 1503.1 06.78